# EUROPEAN PATENT SPECIFICATION

(11) **EP 2 328 176 B1**
(45) Date of publication and mention of the grant of the patent: **25.02.2015**
(21) Application number: 10192131.0
(22) Date of filing: 22.11.2010
(51) Int. Cl.: G02B 3/00, H01L 33/58, H01L 27/15

(54) **Manufacturing method of a display panel**
Herstellungsverfahren für Anzeigetafel
Procédé de fabrication d'un panneau d'affichage

(30) Priority: 25.11.2009 JP 2009267005
(43) Date of publication of application: 01.06.2011
(73) Proprietor: Oki Data Corporation, Tokyo 108-8551 (JP)
(72) Inventor: Tanigawa, Kenichi, Gunma 370-0021 (JP); Fujita, Minoru, Gunma 370-0021 (JP)
(74) Representative: Betten & Resch

(56) References cited:
- EP-A2- 0 753 765
- US-A1- 2002 050 958
- US-A1- 2003 001 986
- US-A1- 2003 207 212

## Description

### BACKGROUND OF THE INVENTION

The present invention relates to a manufacturing method of a display panel.

There are known self-luminous type light emitting elements such as a Light Emitting Diode (LED), an organic electroluminescence (EL) element, an inorganic EL element or the like. Further, there are known non-self-luminous type elements such as a liquid crystal display (LCD).

A self-luminous type light emitting element array is constituted by arranging a plurality of self-luminous type light emitting elements in a matrix. The display apparatus using the self-luminous type light emitting element array exhibits less light loss and higher efficiency than a light-valve type display apparatus such as an LCD. In particular, a direct-view type display apparatus using the self-luminous type light emitting element array can be lightened and thinned, since a backlight can be eliminated.

A projection type display apparatus such as a head up display (HUD), a projector or a rear projection system using the non-self-luminous type light emitting elements needs a separate light source. In contrast, a projection type display apparatus using the self-luminous type light emitting elements does not need such a separate light source, and therefore can be compact in size.

In this regard, for example, in the HUD at a display magnification of 5, light incident on the HUD at an incident angle within an angle range of 10-20 degrees with respect to an optical axis is usable. However, the self-luminous type light emitting element array in which the light emitting elements are arranged in a plane has a light distribution basically exhibiting a Lambert distribution. Therefore, the HUD using the self-luminous type light emitting element array has a light-use efficiency of as low as 3-5 %.

In order to enhance the light-use efficiency, it is conceivable to form a microlens array on the light emitting element array to thereby narrow a spread of the light distribution, i.e., to thereby increase an amount of light incident on the HUD at an incident angle within the above described angle range.

Patent Document No.1 discloses a method of forming the microlens array on the light emitting element array. In the method disclosed by Patent Document No. 1, UV-curable resin (i.e., lens material) is filled in concaves of a stamper made of glass, and then a wafer on which light emitting elements are formed is overlaid over the stamper so that the light emitting elements face the concaves filled with the lens material. Further, a spacer is fixed to a non-effective region of the stamper. The spacer contacts the wafer to determine a thickness of the microlenses.
Patent Document No. 1: Japanese Laid-open Patent Publication No. 2006-327182

However, in the above described method, it is difficult to accurately align the wafer and the stamper with each other. Further, since it is necessary to provide the spacer on the stamper, the number of manufacturing steps increases.

US 2003/0207212 shows a manufacturing method of microlenses comprising the formation of lens pillars and the deposition, patterning and curring of a resist layer to define microlenses.

### SUMMARY OF THE INVENTION

The present invention is intended to provide a manufacturing method of a display panel in which a light emitting element array and a lens array are accurately aligned with respect to each other in a simple manner.

The present invention provides a manufacturing method of a microlens array on a light emitting element array including the steps of
forming a light emitting element array on a substrate, the light emitting element array including a plurality of light emitting elements;
forming a photoresist layer on the light emitting elements;
forming a plurality of lens pillars on the light emitting elements by performing a photolithographic process on said photoresist layer;
laminating a dry film resist on the lens pillars so that gaps are left between the lens pillars and below said dry film resist;
forming a lens portion by performing heat treatment to cause the dry film resist to be softened so that softened dry film resist fills the gaps, wherein said lens portion has a plurality of lenses corresponding to said lens pillars, wherein the lens portion and the lens pillars constitute a microlens array that focuses light emitted by the light emitting elements.

Further scope of applicability of the present invention will become apparent from the detailed description given hereinafter. However, it should be understood that the detailed description and specific embodiments, while indicating preferred embodiments of the invention, are given by way of illustration only, since various changes and modification within the invention will become apparent to those skilled in the art from this detailed description .

### BRIEF DESCRIPTION OF THE DRAWINGS

In the attached drawings;
FIG. 1 is a perspective view showing a display panel using a light emitting element array;
FIG. 2 is a plan view showing a part of the display panel shown in FIG. 1;
FIG. 3 is a circuit diagram showing an equivalent circuit of the display panel shown in FIG. 1;
FIG. 4 is a circuit diagram showing an anode driver IC and cathode driver ICs shown in FIG. 3;
FIG. 5 is a partial plan view showing pixels of a light emitting element array chip shown in FIG. 1;
FIG. 6A is an enlarged view of one of pixels shown in FIG. 5; .
FIGS. 6B and 6C are sectional views respectively taken along line 6B-6B and line 6C-6C;
FIGS. 7A through 7F are sectional views for illustrating a manufacturing process of the light emitting element array chip according to the present invention;
FIG. 8 is a sectional view showing anther configuration example of the light emitting element array chip;
FIGS. 9A through 9F are sectional views for illustrating another manufacturing process of a light emitting element array chip according to the present invention;
FIG. 10 is a schematic view showing a projection-type display apparatus;
FIG. 11 is a schematic view showing a front-projection type display apparatus;
FIG. 12 is a schematic view showing a rear-projection---type display apparatus; and
FIG. 13 is a schematic view showing a rear-projection-type display apparatus.

### DETAILED DESCRIPTION OF THE PREFERRED EMBODIMENT

Hereinafter, embodiments of the present invention will be described with reference to drawings. The drawings are provided for purposes of explanation only and do not limit the scope of this invention.

### FIRST EXAMPLE.

### Configuration of Display Panel

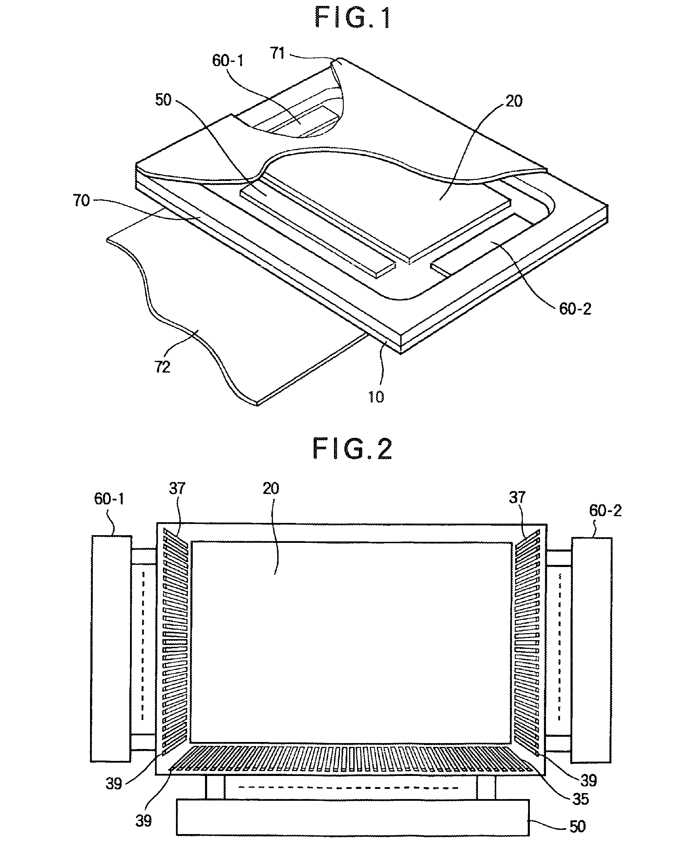

FIG. 1 is a perspective view showing a. display panel 1 using a light emitting element array.

As shown in FIG. 1, the display panel 1 includes a substrate (to be more specific, a chip-on-board substrate) 10 for mounting semiconductor chips. Hereinafter, the chip-on-board substrate 10 will be referred to as the "COB 10". The COB 10 is formed of a glass epoxy substrate, an alumina substrate, an aluminium nitride (AIN) substrate, a metal substrate, a metal core substrate or the like. Not shown wiring patterns or the like are formed on the COB 10.

A light emitting element array chip 20, an anode driver integrated circuit (IC) 50 and cathode driver integrated circuits (ICs) 60-1 and 60-2 are fixed to a surface (i.e., a mounting surface) of the COB 10. The light emitting element array chip 20 is formed of a plurality of thin-film semiconductor light emitting elements (for example, LEDs). The anode driver IC 50 and the cathode driver ICs 60-1 and 60-2 are provided for driving the light emitting element array chip 20.

The light emitting element array chip 20, the anode driver IC 50, and the cathode driver ICs 60-1 and 60-2 are electrically connected to each other via not shown wiring patterns on the COB 10. In this regard, if the anode driver IC 50 and the cathode driver ICs 60-1 and 60-2 are electrically connected to each other using metal wires, the anode driver IC 50 and the cathode driver ICs 60-1 and 60-2 are bonded (adhered) onto the COB 10 fusing silver paste, resin or the like.

A cover 71 is mounted to the COB 10 via a spacer 70 so as to protect the anode driver IC 50 and the cathode driver ICs 60-1 and 60-2. The spacer 70 is in the form of a frame, and has a thickness thicker than a height from the mounting surface of the COB 1C to an uppermost part of the metal wires. The cover 71 has a. display portion corresponding to the light emitting element array chip 20. The display portion of the cover 71 is preferably formed of a material (for example, glass, acrylic resin or polycarbonate resin) having a transmittance of 80 % or more of the visible light. The cover 71 has a peripheral portion around the display portion. The peripheral portion of the cover 71 is preferably formed of opaque material, or is preferably applied with a coating so as to reduce the transmittance to 0.1 % or less of the visible light. As the transmittance of the peripheral portion of the cover 71 is reduced to 0.1 % or less, light emitted from the light emitting element array chip 20 and reflected by the metal wire, the anode driver IC 50 or the cathode driver IC 60-1 or 60-2 is prevented from being emitted outside (i.e., prevented from entering into an image).

A heat sink and a metal housing (not shown) are fixed to a backside of the COB 10. Further, in order to effectively release heat generated by the light emitting element array chip 20, a heat releasing paste or heat releasing sheet (not showy) having insulation property are provided between the backside of the COB 10 and the heat sink or the metal housing.

The COB 10 and the spacer 70 can be bonded to each other using resin or the like. The spacer 70 and the cover 71 can be bonded to each other using resin or the like. It is also possible to form screw-passing holes on the COB 10, the spacer 70 and the cover 71, and to fix the COB 10, the spacer 70 and the cover 71 to each other using screws penetrating through the screw-passing holes and enraging threaded holes on the heat sink or the metal housing. Alternatively, the COB 10 and the spacer 70 can be integrally formed with each other. The spacer 70 and the cover 71 can be integrally formed with each other.

The light emitting element array chip 20, the anode driver IC 50 and the cathode driver ICs 60-1 and 60-2 of the display panel 1 are electrically connected to a not shown control unit via a flat-type flexible cable 72. Although one anode driver IC 50 and two cathode driver ICs 60-1 and 60-2 are provided on the COB 10, it is also possible to provide only one cathode driver TC depending on the circuit structure. Further, the anode driver IC and the cathode driver IC(s) can be arranged in a manner other than that shown in FIG. 1.

FIG. 2 is a plan view of the display panel 1 shown in FIG. 1. In FIG.2, a part of the display panel 1 is omitted.

A plurality of anode wirings 35 and a plurality of cathode wirings 37 are provided around the light emitting element array chip 20. The anode wirings 35 and the cathode wirings 37 are connected to a plurality of pad portions 39 such as wire bonding pads. The anode wirings 35 are electrically connected to the anode driver IC 50 via the pad portions 39. The cathode wirings 37 are electrically connected to the cathode driver IC 60-1 and 60-2 via the pad portions 39.

In the case where a pitch of the light emitting element of the light emitting element array chip 20 is different from that of the pad portions 39, further pad portions are provided on the light emitting element array chip 20 at the same pitch as the light emitting elements, and are connected to the pad portions 39 using connection wires extending obliquely as shown in FIG. 2. In the case where the pitch of the light emitting elements is the same as the pitch of the pad portions 39, the connection wires are not required to extend obliquely.

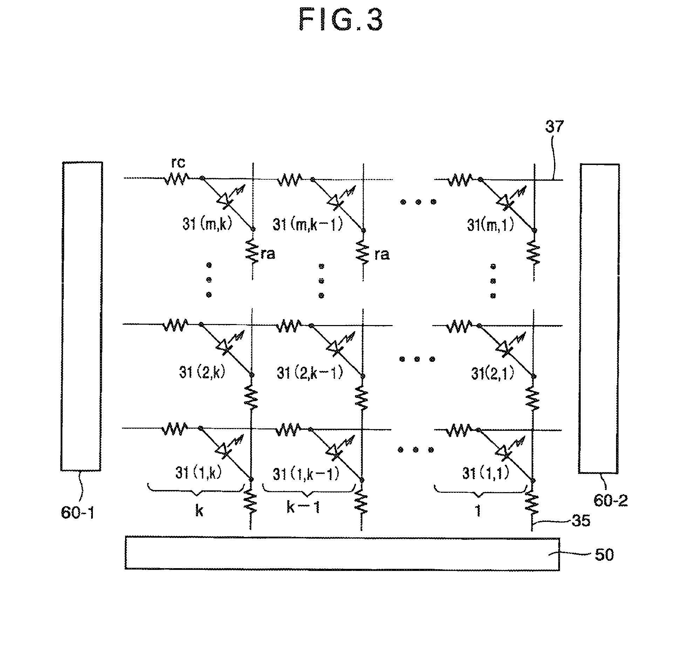

FIG. 3 is a circuit diagram of an equivalent circuit of the display panel 1 shown in FIG. 1.

The light emitting element array chip 20 of the display panel 1 is constituted by a passive-matrix type LED dot matrix of "m" rows and "k" column.

The anode wirings 35 are arranged in parallel to each other in a row direction, and the number of the anode wirings 35 (i.e., the number of columns) is expressed as "'k". The cathode wirings 37 are arrange in parallel to each other in a column direction, and the number of the cathode wirings 37 (i.e., the number of rows) is expressed as "m". LEDs 31 (1, 1) through 31 (m, k) are disposed at crossings between the anode wirings 35 and the cathode wirings 37. The number of the LEDs 31 corresponds to m x k. In this regard, the LED 31 (m, k) indicates the LED 31 disposed at the crossing between the m-th row and the k-the column. The anode wirings 35 respectively have anode wiring resistances ra, and are connected to the anode driver IC 50. The cathode wirings 37 respectively have cathode wiring resistance rc, and are connected to the cathode driver ICs 60-1 and 60-2.

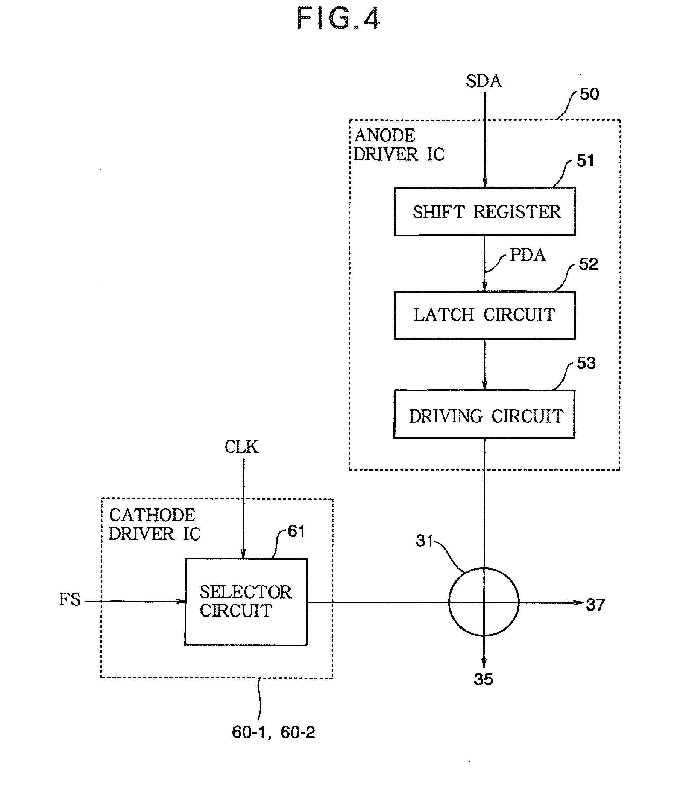

FIG. 4 is a circuit diagram schematically showing the anode driver IC 50 and the cathode driver TCs 60-1 and 60-2 shown in FIG. 3.

The driver IC 50 has a function to flow currents through the columns of the LEDs 31 connected to the anode wirings 35 based on a display data DA sent from the not shown control unit. The display data Da is, for example, light-emission data, i.e., an instruction to emit light or not to emit light. The anode driver IC 50 includes a shift register 51. The shift resister 51 receives a serial light-emission data SDA send from the not shown control unit via serial transmission, performs serial-parallel conversion, and outputs a parallel light-emission data PDA. The anode driver IC 50 further includes a latch circuit 52 connected to an output side of the shift register 51. The latch circuit 52 has a function to latch the parallel light-emission data PDA outputted by the shift register 51. The anode driver IC 50 further includes a driving circuit 53 connected to an output side of the latch circuit 52. The driving circuit 53 has a function to amplify the output signal of the latch circuit 52. The anode wirings 35 are connected to an output side of the driving circuit 53.

The cathode driver ICs 60-1 and 60-2 have function to scan the rows of the LEDs 31 connected to the cathode wirings 37 based on clock signals CLK and frame signals FS sent from the not shown control unit. The cathode driver ICs 60-1 and 60-2 include selector circuits 61 and the like.

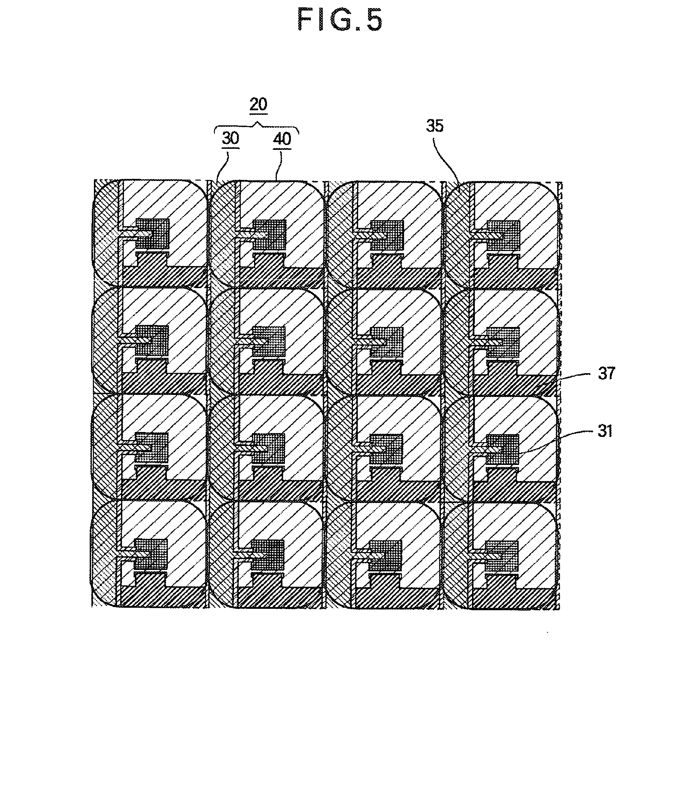

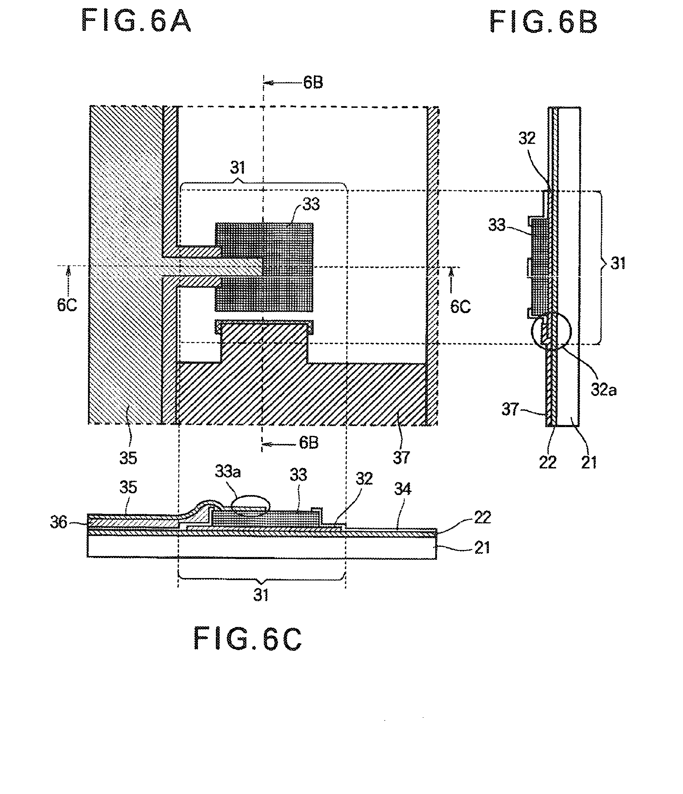

FIG. 5 is a partial plan view showing pixels of 4 x 4 matrix of the light emitting element array chip 20 shown in FIG. 1. FIG. 6A is an enlarged view of one of pixels shown in FIG. 5. FIGS. 6B and 6C are sectional views respectively taken along line 6B-6B and line 6C-6C shown in FIG. 6A.

The light emitting array chip 20 includes a substrate 21 (FIG. 6B), and a light emitting element array 30 provided on the substrate 21. The light emitting element array 30 has LEDs 31 as thin-film semiconductor light emitting elements arranged in a matrix. The light emitting element array 30 further includes a lens array (in this example, a microlens array) 40 provided on and aligned with the respective LEDs 31. The microlens array 40 is provided for focusing light emitted by the light LEDs 31.

As shown in FIGS . 6A through 6C, each LED 31 has a substantially rectangular shape (as seen from above), and are fixed to the substrate 21 via a planarizing layer 22. Each LED 31 includes, for example, an N-type semiconductor layer 32 bonded onto the planarizing layer 22, and further includes a light emitting region 33 for emitting light formed on the N-type semiconductor layer 32. The light emitting region 33 has a substantially rectangular shape (as seen from above), and includes a P-type semiconductor layer 33a and the like. On the planarizing layer 22, the cathode wiring 37 is formed in a band shape to extend in the row direction (horizontally) in the vicinity of each light emitting region 33. The cathode wiring 37 is in ohmic contact with an end portion 32a of the N-type semiconductor layer 32. A periphery of each light emitting region 33 is covered with an insulation film 34. The anode wiring 35 is formed on the insulation film 34 via a thick insulation film 36. The anode wiring 35 is formed in a band shape and extends in the column direction (vertically). The anode wiring 35 is in ohmic contact with a P-type semiconductor layer 33a of the light emitting region 33.

The semiconductor light emitting element array 30 is obtained by, for example, forming the LEDs 31 of thin-film semiconductors on a mother substrate (not shown), separating the LEDs 31 from the mother substrate, and bonding the LEDs 31 onto the substrate 21 to form the LED dot matrix. For this reason, the planarizing layer 22 (as the insulation layer) is formed between the substrate 21 and the LEDs 31. The planarizing layer 22 electrically insulates the respective LEDs 31 (pixels), so as to form the matrix structure.

As shown in FIG. 5, the microlens array 40 includes a plurality of microlenses formed on the LEDs 31 arranged in a matrix. Each microlens has a substantially rectangular shape (as seen from above) whose corners are rounded as shown in FIG. 6. However, the microlens can have a circular shape or other shape that fills pixels.

For example, microlenses of the microlens array 40 have optical axes substantially perpendicular to the surface of the substrate 21.

### Configuration of Light Emitting Element Array Chip

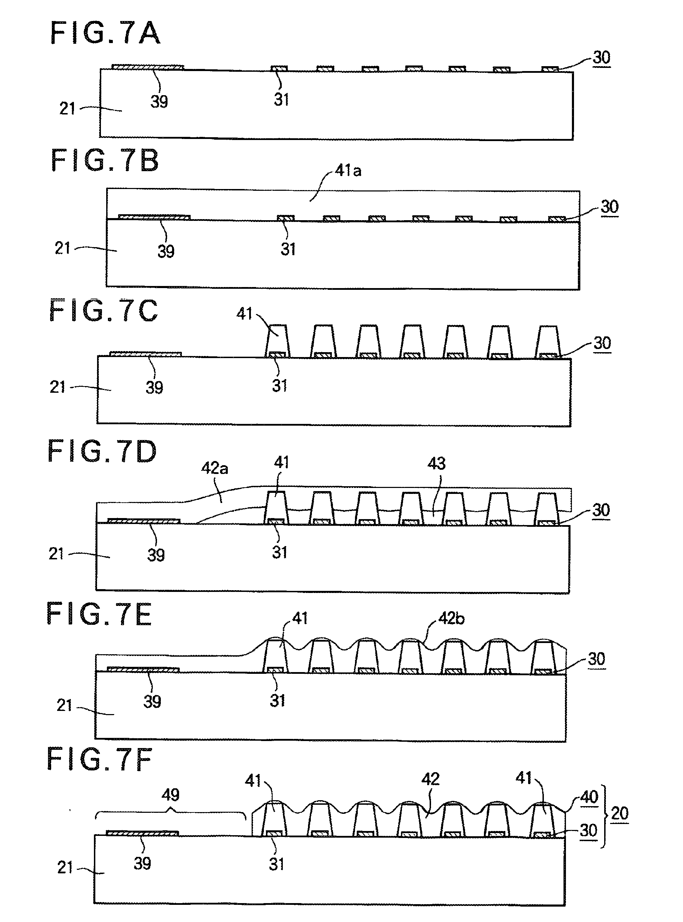

FIGS. 7A through 7F are sectional views for illustrating a manufacturing process of the light emitting element array chip 20 according to the method of the present invention.

As shown in FIG. 7F, the light emitting element array chip 20 includes the light emitting element array 30 including the LEDs 31 arranged in a matrix on the substrate 21. The microlens array 40 is formed on the light emitting element array. 30 except a predetermined region (i.e., a non-effective region) 49. The non-effective region 49 is an opening in which, for example, the pad portions 39 connected to the anode wirings 35 and the cathode wirings 37 (FIG. 2) and the like are provided.

The microlens array 40 includes a plurality of columnar lens pillars 41 each having a trapezoid shape in a vertical section (cut by a plane including optical axes), and a plurality of lens portions 42 formed to cover the lens pillars 41. The lens portions 42 have spherical top surfaces (i.e., curved lens surfaces). The microlens array 40 is configured to focus the light emitted by the LEDs 31.

The lens pillar 41 can be in the form of a circular truncated cone whose cross-sectional shape (cut by a plane parallel to the substrate 21) is circular, or in the form of a polygonal truncated cone whose cross-sectional shape is polygonal.

### Manufacturing Process of Light Emitting Element Array Chip

Next, a manufacturing process of the light emitting element array chip 20 will be described with reference to FIGS. 7A through 7F.

### Formation of Light Emitting Element Array

In a process shown in FIG. 7A, the substrate 21 for mounting the light emitting element array chip 20 is prepared. The substrate 21 can be formed of a semiconductor substrate composed of Si, GaAs, GaP, InP, GaN, ZnO or the like, a ceramic substrate composed of A1N, Al₂O₃ or the like, a glass epoxy substrate, a metal substrate composed of Cu, A1 or the like, or a plastic substrate.

Then, the light emitting element array 30 is formed on the substrate 21. As described with reference to FIGS. 5 through 6C, the light emitting element array 30 includes the LEDs 31 arranged in a matrix. Further, the anode wirings 35, the cathode wirings 37 and the pad portions 39 (see FIG. 2) are formed on the substrate 21.

The LEDs 31 are formed of, for example, epitaxially grown LEDs composed of III-V group compound semiconductor material such as A1N, GaN, InN, InP, GaP, AlP, AlAs, GaAs or InAs (or mixed crystal thereof), or II-VI group compound semiconductor material such as ZnO, ZnSe or CdS. Alternatively, it is possible to use organic-based material.

Electrodes of the LEDs 31, the anode wirings 35, the cathode wirings 37 and the pad portions 39 are formed of, for example, Au-based metal wirings composed of Au, Tu/Pt/Au, Ti/Au, AuGeNi/Au, AuGe/Ni/Au or the like, Al-based metal wirings composed of Al, Ni/Al, Ni/AlNd, Ni/AlSiCu, Ti/Al or the like. Alternatively, it is possible to use an oxide-based transparent electrode.

### Formation of Lens-Pillar-Material Layer

In a process shown in FIG. 7B, a photoresist as lens-pillar-material layer 41a is formed on the substrate 21 to a predetermined thickness. Further, if necessary, the lens-pillar-material layer 41a is subjected to pre-exposure baking.

The lens-pillar-material layer 41a is preferably formed of chemical amplification negative type thick film photoresist or DFR (Dry Film Resist) composed of epoxy-based resin or acryl-based resin.

In terms of ensuring uniformity over the entire surface of the substrate 21, it is preferable to laminate the lens-pillar-material layer 41a (DFR) on the substrate 21 using a laminator . It is also preferable to coat the lens-pillar-material layer 41a (photoresist) on the substrate 21 using a spray coating method.

DFR is an etching film resist and is formed by, for example, coating photoresist resin to form a photoresist layer on a base film, drying the photoresist layer, and laminating a protective film onto the photoresist layer. The DFR has a trilaminar structure with the photoresist layer sandwiched between the base film and the protective film each having a thickness of 20-25 µm. The base film is preferably formed of biaxially-stretched PET (poly ethylene terephthalate) film which is flat and transparent and which has an excellent transmittance of ultraviolet rays. The protective film is preferably formed of LDPE (Low Density Polyethylene) film that has a suitable releasability from the photoresist layer of acryl-based resin and that has a high flatness with low fish eye.

As conventionally known, the protective film is separated (peeled off) from the photoresist layer before the lamination of the DFR, and the base film is separated from the photoresist layer after the lamination of the DFR.

### Formation of Lens Pillars

In a step shown in FIG. 7C, the lens-pillar-material layer 41a is patterned using a photolithographic process to form the lens pillars 41 on the LEDs 31 at predetermined intervals. The vertical section of each lens pillar 41 is trapezoidal. If a stepper (i.e., a reduction projection exposure device) is used to expose the lens-pillar-material layer 41a, the lens pillars 41 of trapezoidal shapes are formed by performing exposure in such a manner that a focal position of a projection lens is shifted upward from a position where the lens pillars 41 are to be formed. It is preferable that an inclination angle of a side surface of each lens pillar 41 with respect to a vertical direction is large, in terms of forming a lens shape close to a hemispherical shape.

### Lamination of Lens-Portion-Material Layer

In a process shown in FIG. 7D, a dry film resist as lens-portion-material layer 42a is laminated on the lens pillars 41 on the substrate 21 using the laminator so as to leave a hollow space between the substrate 21. and the lens-portion-material layer 42a.

The lens-portion-material layer 42a is preferably formed of chemical amplification negative type thick DFR composed of epoxy-based resin or acryl-based resin. In this regard, the lens-portion-material layer 42a and the lens-pillar-material layer 41a can be formed of the same material whose light transmission characteristics are the same as each other, or can be formed of different materials whose light transmission characteristics are different from each there.

To be more specific, as shown in FIG. 7D, after the lens-portion-material layer 42a is laminated on the lens pillars 41 on the substrate 21, the lens-portion-material layer 42a intrudes into spaces between the lens pillars 41, so as to form gaps 43 between the pillars 41 and below the lens-portion-material layer 42a. This is achieved by reducing air pressure in a laminator chamber to a predetermined air pressure at a predetermined temperature. It is preferable that the thickness T2 of the lens-portion-material layer 42a is thinner than the height T1. of the lens pillars 41 (i.e., T2 < T1), in terms of forming the gaps 43.

### Heat Treatment for Softening

The lens-pillar-material layer 41a and the lens-portion-material layer 42a are composed of negative type photoresist, and are patterned using a photolithographic process including lamination (or coating), pre-exposure baking (if necessary), exposure, post-exposure baking and development. Through the exposure, post-exposure baking and development steps, the negative-type photoresist becomes polymerized. A bonding strength between molecules of the polymerized photoresist is stronger than that of the non-polymerized photoresist, (i.e., before exposure, post-exposure baking and development). A softening temperature of the non-polymerized photoresist (i.e., precursor material) is lower than that of the polymerized photoresist.

In this state, the lens-portion-material layer 42a is not yet polymerized, but the lens pillars 41 (patterned by the photolithographic process) are polymerized. Therefore, heat treatment is performed so as to cause the lens-portion-material layer 42a to be softened to fall into the gaps 43, while the lens pillars 41 do not change their shapes. The heat treatment is performed at a temperature such that the lens-portion-material layer 42a is softened but that the lens pillars 41 do not change their shapes.

With such a temperature, the lens-portion-material layer 42a is imparted with lens shapes (i.e., in the form of microlenses) and fills the gaps 43 as shown in FIG. 7E. The lens-portion-material layer 42a having the lens shapes is referred to as precursor lens portions 42b. The thickness of the lens-portion-material layer 42a and the thickness of the lens pillars 41 determine the shape and thickness of the microlenses, and therefore it is preferable to choose an optimum combination thereof so as to obtain desired curvatures and thickness of the microlenses.

### Formation of Lens portions

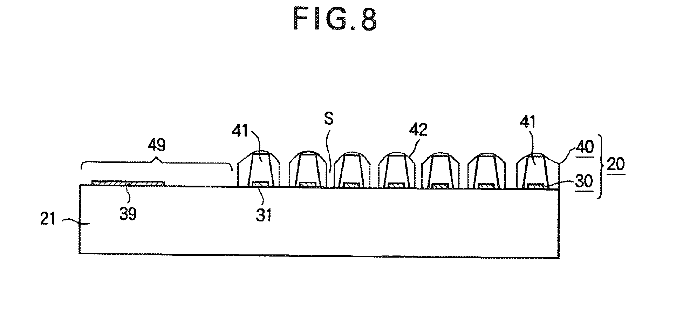

In a step shown in FIG. 7F, the precursor lens portions 42b are patterned using photolithographic process (including at least exposure, post-exposure baking and development) to remove the non-effective region 49 corresponding to the pad portions 39 and the like. Through the photolithographic process, the precursor lens portions 42b are polymerized, and polymerized lens portions 42 are formed. In this step, it is also possible to perform patterning to form slits S between adjacent microlenses to separate adjacent microlenses as shown in FIG. 8.

Next, the polymerized lens portions 42 are subjected to baking, with the result the microlens array 40 including the lens pillars 41 and the lens portions 42 is obtained. In this regard, if residue regains on the non-effective region 49, the residue can be removed by plasma treatment using oxygen, argon or the like.

Thereafter, the light emitting element array chip 20, the anode driver IC 50 and the cathode driver ICs 60-1 and 60-2 (FIGS. 1 and 2) are fixed to the surface of the COB (chip-on-board substrate) 10.

### Operation of Display Panel

Next, an operation of the display panel 1 (FIGS. 1 through 7F) will be described.

When display information is inputted to the control 1 unit (not shown) of the display panel 1, the control unit sends the serial light-emission data SDA based on the display information to the anode driver IC 50 shown in FIG. 4.

Then. the serial light-emission data SDA for the LEDs 31 of the first row of the light emitting element array 30 are stored sequentially in the shift resistor 51 of the anode driver IC 50. The serial light-emission data SDA stored in the shift register 51 are converted into parallel light-emission data PDA by the shift register 51, and stored in the latch circuit 52. Output signals of the latch circuit 52 are amplified by the driving circuit 53, and outputted as constant electric current from the driving circuit 53 to be supplied to anode, electrodes or the LEDs 31 via the anode wirings 35.

In this state, when the clock signals CLK and the frame signals FS (outputted from the control unit) are inputted to the cathode driver ICs 60-1 and 60-2, the selector circuits 61 of the cathode driver ICs 60-1 and 60-2 selects the cathode wiring 37 of the first row. Therefore, driving currents are supplied, to the LEDs 31 of the first row from the anode wirings 35. That is, the LEDs 31 of the first row emit light based on the serial light-emission data SDA.. The light emitted by the LEDs 31. is focused by the microlenses of the microlens array 40 shown in FIG. 7F, and is emitted outside .

This light emission process is repeated by the number of the cathode wirings 37 (i.e., the number of rows), and image light containing information to be displayed is emitted outside from the light emitting element array chip 20.

### Advantages

The manufacturing method provides the following advantages.

The microlens array 40 can be patterned in a similar manner to the conventional photolithographic process. In particular, the microlens array 40 is formed by forming the lens pillars 41 on the LEDs 31, and forming the lens portion 42 to cover the lens pillars 41. Therefore, the microlenses can be accurately aligned with the LEDs 31. In other words, positioning accuracy of the microlenses and the LEDs 31 can be enhance.

Further, the microlens array 40 can be formed in a simple manner without requiring special equipment.

Furthermore, the microlens array 40 having the thickness of, for example, 10 µm or more can be formed without using a mold as conventionally used (i.e., a stamper with a spacer disclosed in Patent Document No.1).

Moreover, the curvatures and thickness of the microlenses of the microlens array 4.0 can be arbitrarily adjusted.

Additionally, in the laminating step of FIG. 7D, the lens-portion-material layer 42a intrude into the gaps 43 between the adjacent lens pillars 41, and therefore a strong adhesion force is generated between the precursor lens portions 42b and the lens pillars 41. With this adhesion force, rupture or peeling between the lens pillars 41 and the precursor lens portions 42 can be prevented in the heat treatment step shown in FIG. 7E, and air in the gaps 43 can be smoothly released outside.

### SECOND EXAMPLE.

The display panel 1 of the second example is different from the display panel 1 of the first example in the configuration and manufacturing method of the light emitting element array chip 20 (20A). Other components of the display panel 1 of the second example are the same. Hereinafter, the light emitting element array chip 20A of the second example will be described.

### Configuration of Light Emitting Element Array Chip

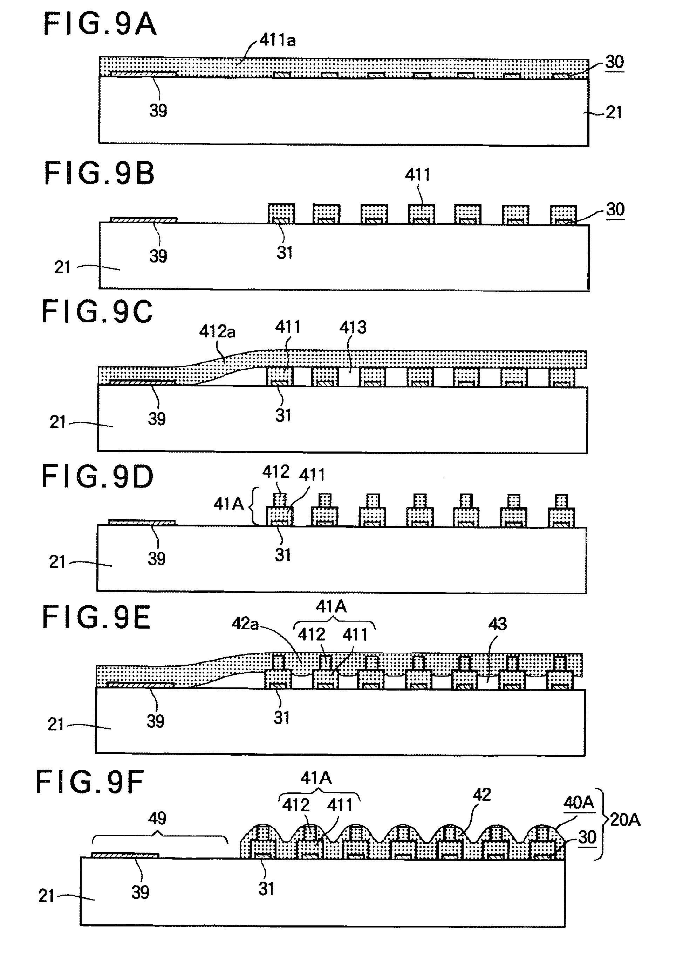

FIGS. 9A through 9F are sectional views for illustrating an inventive manufacturing process of the light emitting element array chip 20A of the second example. Components that are the same as those of the first example are assigned the same reference numerals.

As shown in FIG. 9F, the light emitting array chip 20A of the second example includes a light emitting element array 30 including a plurality of LEDs 31 arranged in a matrix on the substrate 21, as described in the first example. The microlens array 40A is formed on the light emitting element array 30 except the predetermined non-effective region 49. The microlens array 40A has a structure different from the microlens array 40.

The microlens array 40A includes a plurality of lens pillars 41A formed on the respective LEDs 31. Each lens pillar 41A has a tiered structure including a plurality of parts (as pillar portions) arranged vertically, i.e., in a direction perpendicular to the substrate 21. For example, each lens pillar 41A includes two parts (i.e., upper and lower parts) of different sizes. The microlens array 40A further includes a plurality of lens portions 42 formed to cover the lens pillars 41A and having spherical top surfaces (i.e., curved lens surfaces), as described in the first embodiment. The lens portions 42 are configured to focus the lights emitted by the respective LEDs 31.

The lens pillar 41A includes a lower lens pillar 411 formed on the LED 31 and an upper lens pillar 412 formed on the lower lens pillar 411. The lower lens pillar 411 and the upper lens pillar 412 have columnar shapes whose vertical section is rectangular. A cross sectional area of the upper lens pillar 412 is smaller than that of the lower lens pillar 411.

### Manufacturing Process of Light Emitting Element Array Chip

The manufacturing process of the light emitting element array chip 20A will be described with reference to FIGS. 9A through 9F.

### Formation of Lower Lens Pillar

In a step shown in FIG. 9A, the substrate 21 for mounting the light emitting lens array chip 20A is prepared, and the light emitting element array 30 is formed on the substrate 21 as described in the first example. The light emitting array 30 includes the LEDs 31 arranged in a matrix. Further, the anode wirings 35 and the cathode wirings 37 and the pad portions 39 (see FIG. 2) are formed on the substrate 21.

Then, a lower-lens-pillar-material layer 411a is formed on the substate 21 to a predetermined thickness. If necessary, the lower-lens-pillar-material layer 411a is subjected to pre-exposure baking. The lower-lens-pillar-material layer 411a is formed of DFR as described in the first embodiment.

In terms of ensuring uniformity over the entire surface of the substrate 21, it is preferable to laminated the lower-lens-pillar-material layer 411a (DFR) on the substrate 21 using a laminator. It is also preferable to coat the lower-lens-pillar-material layer 411a (photoresist) on the substrate 21 using a spray coating method.

Next, as shown in FIG. 9B, the lower-lens-pillar-material layer 411a is patterned using a photolithographic process, so as to form the lower lens pillars 411 on the LEDs 31 at predetermined intervals. The lower lens pillars 411 have columnar shapes whose vertical sections are rectangular.

### Lamination of Upper-Lens-Pillar-Material Layer

In a step shown in FIG. 9C, an upper-lens-pillar-material layer 412a is laminated on the lower lens pillars 411. The upper-lens-pillar-material layer 412a is preferably formed of DFR. In this step, it is preferable to use a laminator to laminate the upper-lens-pillar-material layer 412a (DFR) so that gaps 413 are formed between the lower lens pillars 411 and below the upper-lens-pillar-material layer 412a.

### Formation of Upper Lens Pillars

In a step shown in FIG. 9D, the upper-lens-pillar-material layer 412a is patterned using a photolithographic process to form upper lens pillars 412 respectively on the lower lens pillars 411. The patterning is performed so that the each upper lens pillar 412 has a cross sectional area smaller than that of the lower lens pillar 411, and the vertical section of each upper lens pillar 412 is rectangular.

The upper lens pillars 4.2 and the lower lens pillars 411 constitute the lens pillars 41A.

### Lamination of Lens-Portion-Material Layer

In a step shown in FIG. 9E, a lens-portion-material layer 42a is laminated on the lens pillars 41A so as to form gaps 43 between the adjacent lens pillars 41A and below the lens-portion-material layer 42, as described with reference to FIG. 7D in the first embodiment. The lens-portion-material layer 42a is formed of DFR.

Furtherrnore, the lens-portion-material layer 42a is subjected to the heat treatment as was described with reference to FIG. 7D in the first embodiment, and precursor lens portions having the lens shapes (i.e., in the form of microlenses) are formed.

### Formation of Lens portions

In a step shown in FIG. 9F, the precursor lens portions are patterned using a photolithographic process to remove the non-effective region 49, as described with reference to FIG. 7F in the first embodiment. Through the photolithographic process the precursor lens portions are polymerized, so that polymerized lens portions 42 are formed. In this step, it is also possible to perform patterning to form slits between adjacent microlenses (see FIG. 8).

Next, the polymerized lens portions 42 are subjected to baking, with the result the microlens array 40 including the lens pillars 41A and the lens portions 42 is obtained. As was described in the first embodiment, if residue remains on the non-effective region 49, the residue can be removed by plasma treatment using oxygen, argon or the like.

Thereafter, the light emitting element array chip 20, the anode driver IC 50 and the cathode driver ICs 60-1 and 60-2 (FIGS. 1 and 2) are fixed to the surface of the COB (chip-on-board substrate) 10.

### [Operation of Display Panel]

The display panel 1 of the second example operates in a similar manner to the display panel 1 of the first example.

### Advantages

The Display panel 1 according to the second example and the inventive manufacturing method thereof further provide the following advantages.

Since each lens pillar 41A is formed to include a plurality of tiers, it becomes possible to form the microlenses of large aspect ratio.

Since each lens pillar 41A is formed to include a plurality of tiers, top surface area of each lens pillar 411 is smaller than the pitch of the LEDs 31. Therefore, a relatively large amount of the lens-portion-material layer 42 intrudes into the gaps 43 in the heat treatment (FIG. 9E). As a result, it becomes possible to form microlens array 40 whose lens shape is more close to hemispherical shape. Moreover, since the lens pillars 41A are not required to have trapezoidal shapes in the vertical section, the formation of the lens pillars 41A can be simpler than in the first embodiment.

### Modifications.

The second example can be modified as follows.

In the second example, the lower lens pillars 411 and the upper lens pillars 412 have rectangular shapes in the vertical section. However, it is also possible that the lower lens pillars 411 and the upper lens pillars 412 have trapezoidal shapes in the vertical section. If a stepper is used in the step shown in FIG. 9B, the lower lens pillars 411 having trapezoidal shapes can be formed by exposing the lower-lens-pillar forming layer 411a in such a manner that a focal position of the projection lens is shifted upward from a position where the lower lens pillars 411 are to be formed. Similarly, if a stepper is used in the step shown in FIG. 9D, the upper lens pillars 412 having trapezoidal shapes can be formed by exposing the upper-lens-pillar forming layer 412a in such a manner that the focal position of the projection lens is shifted upward from a position where the upper lens pillars 412 are to be formed.

In the second embodiment, each lens pillar 41 is formed to include two tiers. However, the lens pillar 41 can be formed to include three or more tiers, by repeating the above described steps as necessary. With such a structure, the curvatures and thickness of the microlenses of the microlens array 40 can be finely adjusted.

### THIRD EXAMPLE.

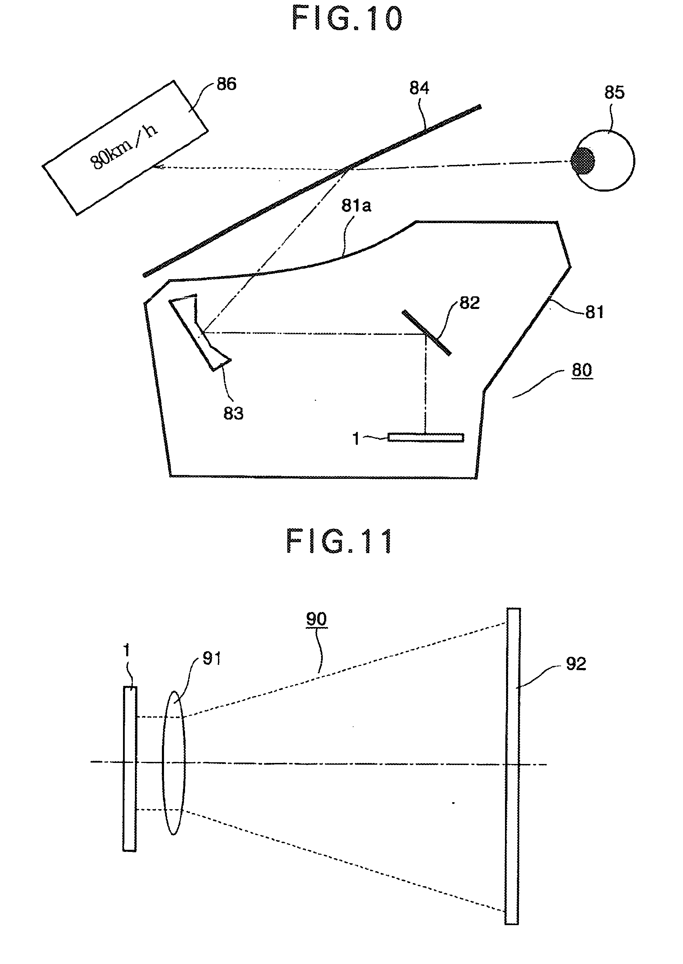

FIG. 10 is a schematic view showing a projection type display apparatus 80 using the display panel 1 according to the first or second example.

The projection type display apparatus 80 is, for example, an HUD (Head Up Display) provided in a vehicle, aircraft or the like. The projection type display apparatus 80 is configured to display various kinds of information, for example, information outputted by various indicators such as a speed meter or fuel meter, map information outputted by a navigation system, image information outputted by an imaging device, or the like. The projection type display apparatus 80 has a housing 81 having a window 81a on a top surface thereof. The housing 81 is mounted to, for example, a backside of an instrument panel of the vehicle. The display panel 1 is mounted to a lower part of the housing 81.

An optical system is provided above and on a light emission side of the display panel 1, and projects light emitted by the display panel 1. For example, optical system includes a reflection plane mirror 82 and an enlargement concave mirror 83. The reflection plane mirror 82 reflects the light emitted by the display panel 1 in a predetermined direction (for example, substantially in a horizontal direction). The enlargement concave mirror 83 is disposed on a reflection side of the reflection plane mirror 82. The enlargement concave mirror 83 focuses the light from the reflection plane mirror 82 on a windshield plate 84 (i.e., plate glass) via the window 81a of the housing 80, so as to form an image on the windshield plate 84 in an enlarged scale.

Next, an operation of the projection type display apparatus 80 will be described.

When a control unit (not shown) of the projection type display apparatus 80 (HUD) receives information to be displayed, the control unit supplies the serial light-emission data SDA based on the display information to the anode driver IC 50 (FIG. 4) of the display panel 1, and supplies the clock signals CLK and the frame signals FS to the cathode driver ICs 60-1 and 60-2 (FIG. 4) of the display panel 1. With this, the LEDs 31 of the light emitting element array 30 of the display panel 1 emit light, and the light is emitted via the microlens array 40 to the outside of the display panel 1.

The light emitted by the display panel 1 is reflected by the reflection plane mirror 82 and the concave mirror 83 (FIG. 10), and is incident on the windshield plate 84 to form a virtual image 86 on a front side of the windshield plate 84. Therefore, a driver 85 can see various kinds of information contained in the image formed by the light emitted by the display apparatus 1, while keeping eyes on the front side.

Next, advantages of the third example will be described.

The projection type display apparatus 80 of the third example uses the display panel 1 of the first or second example, and therefore a spread of the light distribution emitted by the light emitting element array 30 is narrowed by the microlens array 40. In other words, a directivity of the light emitted by the display panel 1 is enhanced, and therefore the light use efficiency is enhanced. Thus, even if a length of a light path from an emitting surface of the display panel 1 to an image projection surface (i.e., the windshield plate 84) is long, the light emitted by the display panel 1 can be efficiently projected on the image projection surface. Further, the HUD as the projection type display apparatus 80 can be simple in structure and compact in size.

In this example, the optical system includes the reflection plane mirror 82 and the enlargement concave mirror 83 that change the direction of the light and project an image in an enlarged scale. However, elements of the optical system are not limited to these mirrors. For example, it is also possible to use a half mirror or a beam splitter that divides the light from the display panel 1. Further, it is also possible to use a dichroic mirror or a dichroic prism that separates the light of certain wavelengths from the light emitted by the display panel 1.

### FOURTH EXAMPLE.

FIG. 11 is a schematic view showing a front-projection type display apparatus 90 according to the fourth example using the display panel 1 according to the first or second example.

The front-projection type display apparatus 90 is, for example, a front projector. The front-projection type display apparatus 90 includes the display panel 1. The light emitted by the display panel 1 is projected on a screen 92 via an optical system 91 such as a projection lens so that an image is formed on the screen 92 in an enlarged scale.

The front-projection type display apparatus 90 provides substantially the same advantages as described in the third example.

### FIFTH EXAMPLE.

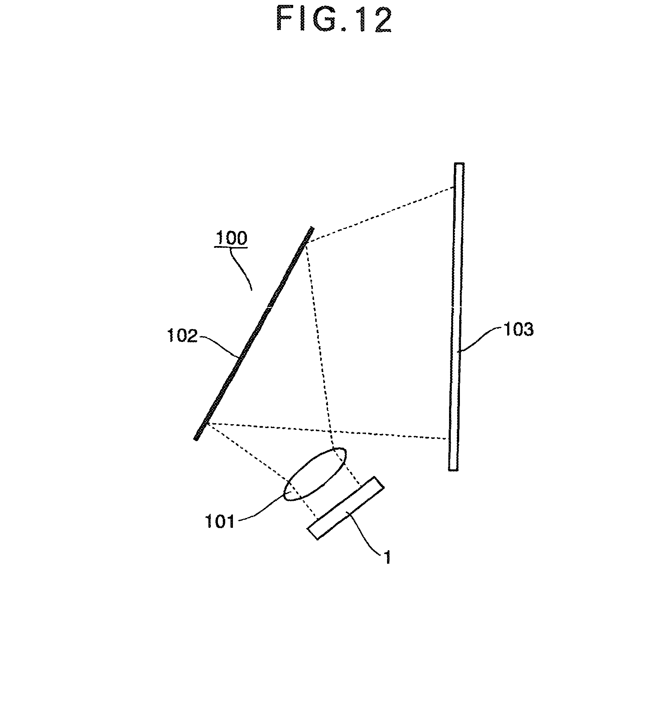

FIG. 12 is a schematic view showing a rear-projection type display apparatus 100 according to the fifth example using the display panel 1 according to the first or second example.

The rear-projection type display apparatus 100 is, for example, a rear projector. The rear-projection type display apparatus 100 includes the display panel 1, and an optical system such as a projection lens 101 and a reflection mirror 102 that reflects the light emitted by the display panel 1 to a screen 103 so as to project an image on the screen 103 in an enlarged scale from backside.

The rear-projection type display apparatus 100 of the fifth example provides substantially the same effects as described in the third example.

### SIXTH EXAMPLE.

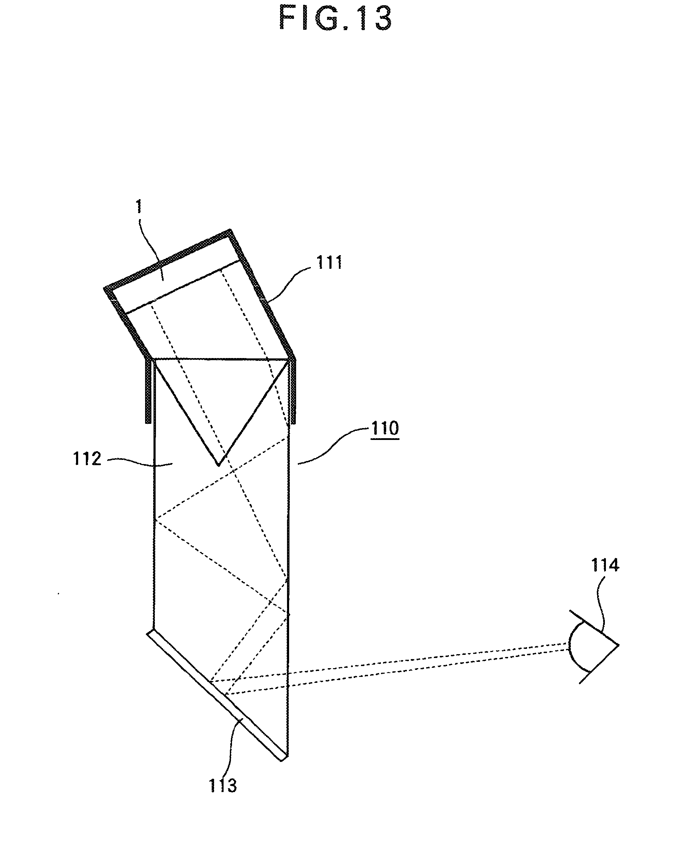

FIG. 13 is a schematic view showing a display apparatus 110 according to the sixth example using the display panel 1 according to the first or second example.

The display apparatus 110 is, for example, a head mount display mounted to eyeglass. The display apparatus 110 includes the display panel 1, and a case 111 that houses the display panel 1. An eyepiece optical system is fixed to the case 111. The eyepiece optical system includes, for example, a prism 112 and a sheet-like hologram optical element 113 fixed to a lower end of the prism 112.

The light emitted by the display panel 1 is incident on the prism 112, reflected inside the prism 112, and reaches the hologram optical element 113 provided at the lower end of the prism 112. The hologram optical element 113 causes interference of lights and forms a virtual image viewable by an eye 114 of a user. Therefore, the user is able to view the image formed by the light emitted by the display panel 1.

The display apparatus 110 of the sixth example provides substantially the same effects as described in the third example.

The above described first to sixth examples and the modifications thereof can be further modified as follows.

The configuration and manufacturing method of the display panel 1 of the first and second examples can be modified to other configuration and manufacturing method. To be more specific, although the semiconductor light emitting array 30 of the first or second example, includes LEDs 31, the LEDs 31 can be replaced with EL elements formed of organic or inorganic material. Such a modification offers substantially the same advantages as those of the first and second examples.

Further, the display panel 1 of the first and second example can be employed in other display devices than those of the third through sixth examples. For example, the display panel 1 of the first and second example is applicable to a direct-view-type display device that does not use a projection optical system other than the microlens array. In this case, the display device having high directivity and having high resolution in a certain direction is obtained.

While the preferred embodiments of the present invention have been illustrated in detail, it should be apparent that modifications and improvements may be made to the invention without departing from the invention as described in the following claims.

## Claims

1. A manufacturing method of a microlens array (40) on a light emitting element array (30) comprising the steps of:
forming a light emitting element array (30) on a substrate (21), said light emitting element array (30) including a plurality of light emitting elements (31);
forming a photoresist layer (41 a) on said light emitting elements (31);
forming a plurality of lens pillars (41) on said light emitting elements (31) by performing a photolithographic process on said photoresist layer (41a);
laminating a dry film resist (42a) on said lens pillars (41) so that gaps (43) are left between said lens pillars (41) and below said dry film resist (42a); and
forming a lens portion (42, 42b) by performing heat treatment to cause said dry film resist (42a) to be softened so that softened dry film resist (42a) fills said gaps (43), wherein said lens portion (42, 42b) has a plurality of lenses corresponding to said lens pillars (41), wherein said lens portion (42, 42b) and said lens pillars (41) constitute a microlens array (40) that focuses light emitted by said light emitting elements (31).

2. The manufacturing method according to claim 1, after said forming of said lens portion (42, 42b), further comprising a step of:
patterning said lens portion (42, 42b) using a photolithographic process to form an opening (49) for providing a pad portion (39) therein, wherein said pad portion (39) can be used to supply driving signals to said light emitting elements (31).

3. The manufacturing method according to claim 1 or 2, wherein said photoresist (41a) is a first dry film resist (411a), and wherein said lens pillars (41) are first lens pillars (411) having a rectangular vertical cross section;
after said forming of said first lens pillars (411), the manufacturing method further comprising the steps of:
laminating a second dry film resist (412a) on said first lens pillars (411),
forming a plurality of second lens pillars (412) on said first lens pillars (411) by performing a photolithographic process on said second dry film resist (412a), wherein the cross sectional area of said second lens pillar (412) is smaller than the cross sectional area of said first lens pillar (411), and the vertical cross section of the second lens pillar (412) is rectangular.

## Patentansprüche

1. Herstellungsverfahren eines Mikrolinsenfeldes (40) auf einem Feld lichtemittierender Elemente (30), umfassend die Schritte:
Bilden eines Feldes lichtemittierender Elemente (30) auf einem Substrat (21), wobei das Feld lichtemittierender Elemente (30) eine Mehrzahl von lichtemittierenden Elementen (31) enthält;
Bilden einer Photolackschicht (41 a) auf den lichtemittierenden Elementen (31);
Bilden einer Mehrzahl von Linsensäulen (41) auf den lichtemittierenden Elementen (31) durch Durchführen eines photolithographischen Prozesses auf der Photolackschicht (41a);
Laminieren eines Trockenfilmlacks (42a) auf den Linsensäulen (41) derart, dass Lücken (43) zwischen den Linsensäulen (41) und unterhalb des Trockenfilmlacks (42a) verbleiben; und
Bilden eines Linsenbereichs (42, 42b) durch Durchführen von Hitzebehandlung, um den Trockenfilmlack (42a) dazu zu bringen, dass er sich derart aufweicht, dass der aufgeweichte Trockenfilmlack (42a) die Lücken (43) füllt, wobei der Linsenbereich (42, 42b) eine Mehrzahl von Linsen aufweist, welche den Linsensäulen (41) entsprechen, wobei der Linsenbereich (42, 42b) und die Linsensäulen (41) ein Mikrolinsenfeld (40) bilden, welches durch die lichtemittierenden Elemente (31) emittiertes Licht fokussiert.

2. Herstellungsverfahren nach Anspruch 1, ferner umfassend nach dem Bilden des Linsenbereichs (42, 42b) einen Schritt:
Strukturieren des Linsenbereichs (42, 42b) mittels eines photolithographischen Prozesses, um eine Öffnung (49) zum Bereitstellen eines Plättchenbereichs (39) darin zu bilden, wobei der Plättchenbereich (39) verwendet werden kann, um Antriebssignale an die lichtemittierenden Elemente (31) zuzuführen.

3. Herstellungsverfahren nach Anspruch 1 oder 2, wobei der Photolack (41 a) ein erster Trockenfilmlack (411 a) ist, und wobei die Linsensäulen (41) erste Linsensäulen (411) sind, welche einen rechteckigen vertikalen Querschnitt aufweisen;
wobei das Herstellungsverfahren nach dem Bilden der ersten Linsensäulen (411) ferner die Schritte umfasst:
Laminieren eines zweiten Trockenfilmlacks (412a) auf den ersten Linsensäulen (411),
Bilden einer Mehrzahl von zweiten Linsensäulen (412) auf den ersten Linsensäulen (411) durch Durchführen eines photolithographischen Prozesses auf dem zweiten Trockenfilmlack (412a), wobei der Querschnittsbereich der zweiten Linsensäule (412) kleiner als der Querschnittsbereich der ersten Linsensäule (411) ist, und wobei der vertikale Querschnitt der zweiten Linsensäule (412) rechteckig ist.

## Revendications

1. Procédé de fabrication d'un réseau de microlentilles (40) sur un réseau d'éléments électroluminescents (30) comprenant les étapes qui consistent :
à former un réseau d'éléments électroluminescents (30) sur un substrat (21), ledit réseau d'éléments électroluminescents (30) comportant une pluralité d'éléments électroluminescents (31) ;
à former une couche de résine photosensible (41a) sur lesdits éléments électroluminescents (31) ;
à former une pluralité de piliers de lentilles (41) sur lesdits éléments électroluminescents (31) en effectuant un processus photolithographique sur ladite couche de résine photosensible (41a) ;
à stratifier une réserve sous forme de film sec (42a) sur lesdits piliers de lentilles (41) de sorte que des espaces (43) soient laissés entre lesdits piliers de lentilles (41) et en dessous de ladite réserve sous forme de film sec (42a) ; et
à former une partie de lentille (42, 42b) en effectuant un traitement thermique pour amener ladite réserve sous forme de film sec (42a) à se ramollir de sorte qu'une réserve sous forme de film sec ramollie (42a) remplisse lesdits espaces (43), où ladite partie de lentille (42, 42b) a une pluralité de lentilles correspondant auxdits piliers de lentilles (41), où ladite partie de lentille (42, 42b) et lesdits piliers de lentilles (41) constituent un réseau de microlentilles (40) qui focalise la lumière émise par lesdits éléments électroluminescents (31).

2. Procédé de fabrication selon la revendication 1, après ladite formation de ladite partie de lentille (42, 42b), comprenant en outre une étape qui consiste :
à former des motifs sur ladite partie de lentille (42, 42b) en utilisant un processus photolithographique pour former une ouverture (49) afin de fournir une partie de plot (39) dedans, 1 où ladite partie de plot (39) peut être utilisée pour fournir des signaux d'attaque auxdits éléments électroluminescents (31).

3. Procédé de fabrication selon la revendication 1 ou 2, dans lequel ladite résine photosensible (41a) est une première réserve sous forme de film sec (411a), et dans lequel lesdits piliers de lentilles (41) sont des premiers piliers de lentilles (411) ayant une coupe transversale verticale rectangulaire ;
après ladite formation desdits premiers piliers de lentilles (411), le procédé de fabrication comprenant en outre les étapes qui consistent :
à stratifier une deuxième réserve sous forme de film sec (412a) sur lesdits premiers piliers de lentilles (411),
à former une pluralité de deuxièmes piliers de lentilles (412) sur lesdits premiers piliers de lentilles (411) en effectuant un processus photolithographique sur ladite deuxième réserve sous forme de film sec (412a), où la superficie en coupe transversale dudit deuxième pilier de lentille (412) est plus petite que la superficie en coupe transversale dudit premier pilier de lentille (411), et la coupe transversale verticale du deuxième pilier de lentille (412) est rectangulaire.
